# EUROPEAN PATENT APPLICATION

(11) **EP 4 651 372 A1**
(43) Date of publication of application: **19.11.2025**
(21) Application number: 24305770.0
(22) Date of filing: 17.05.2024
(51) Int. Cl.: H03F 1/02, H03F 1/56, H03F 3/195, H03F 3/24

(54) **DOHERTY POWER AMPLIFIER WITH RECONFIGURABLE OUTPUT IMPEDANCE TRANSFORMER**

(71) Applicant: NXP USA, Inc., Austin TX 78735 (US)
(72) Inventor: Greene, Matthew Russell, 5656AG Eindhoven (NL); Clarke, Philip Raoul, 5656AG Eindhoven (NL); Lamy, Anthony, 31023 Toulouse (FR)
(74) Representative: Hardingham, Christopher Mark

(57) **Abstract**

A Doherty power amplifier includes a combining node is coupled to a carrier amplifier output and to a peaking amplifier output, and a reconfigurable output impedance transformer coupled between the combining node and a radio frequency (RF) output. The combining node is configured to combine an amplified carrier signal and an amplified peaking signal to produce a combined amplified signal. The reconfigurable output impedance transformer includes a phase shift element, a first variable capacitor, and a second variable capacitor. The phase shift element has an input end coupled to the combining node and an output end coupled to the RF output, and the phase shift element is configured to apply a phase shift to the combined amplified signal. The first variable capacitor is coupled to the input end of the first phase shift element, and the second variable capacitor coupled to the output end of the first phase shift element.

## Description

### TECHNICAL FIELD

Embodiments of the subject matter described herein relate generally to Doherty power amplifiers.

### BACKGROUND

To facilitate radio frequency (RF) communication with mobile units, a cellular base station typically includes one or more fixed RF transceivers coupled to one or more antennas. In some cases, the transmitter and the receiver of each RF transceiver are coupled through a circulator or an RF switch to the antenna. The circulator or switch functions to direct signals received from the transmitter to the antenna, and to direct signals received from the antenna to the receiver.

The Doherty power amplifier is often used in cellular infrastructure transmitters due to its ability to accommodate signals with high peak-to-average power ratios with potentially excellent RF performance (e.g., high gain, high efficiency, good linearity). In order to achieve the best performance, certain aspects of the Doherty power amplifier should be specifically designed based on the expected (or known) load impedance of the base station. For example, the load impedance may be governed by the circulator impedance, the antenna impedance, and other factors (e.g., circuit board layout, filter impedance, environmental factors, and so on).

That said, a particular Doherty power amplifier design may have good RF performance when it is coupled to a load impedance for which it was designed, but the RF performance of that same Doherty power amplifier design may be impaired if the Doherty power amplifier is coupled to a load with a different load impedance (e.g., when the Doherty power amplifier is coupled to a different circulator or antenna). Accordingly, an amplifier supplier should customize each Doherty power amplifier design for the known or anticipated impedance associated with a base station load. This need for customization may consume significant engineering time on the part of the amplifier supplier.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a simplified block diagram of an example RF transceiver system;
FIG. 2 is a simplified block diagram of another example RF transceiver system;
FIG. 3 is a schematic drawing of a Doherty power amplifier with a reconfigurable output impedance transformer, in accordance with an example embodiment;
FIG. 4 is a Smith chart showing a tuning map for an embodiment of a reconfigurable output transformer, in accordance with an example embodiment;
FIG. 5A is a chart plotting return loss versus reflection coefficient for an example embodiment of a Doherty power amplifier;
FIG. 5B is a chart plotting insertion loss versus phase shift for an example embodiment of a Doherty power amplifier;
FIG. 5C is a chart plotting capacitance tuning ratios versus phase shift for an example embodiment of a Doherty power amplifier;
FIG. 6 is a schematic drawing of a Doherty power amplifier with a reconfigurable output impedance transformer, in accordance with another example embodiment;
FIG. 7 is a schematic drawing of a Doherty power amplifier with a reconfigurable output impedance transformer, in accordance with yet another example embodiment;
FIG. 8 is a schematic drawing of a Doherty power amplifier with a reconfigurable output impedance transformer, in accordance with yet another example embodiment;
FIG. 9 is a top view of a physical implementation of a Doherty power amplifier module with a reconfigurable output impedance transformer, in accordance with an example embodiment;
FIG. 10 includes two graphs comparing RF performance metrics for a Doherty power amplifier with a fixed output impedance transformer with RF performance metrics for an embodiment of a Doherty power amplifier with a reconfigurable output impedance transformer; and
FIG. 11 is a flowchart of a method for configuring an embodiment of the reconfigurable output impedance transformer.

### DETAILED DESCRIPTION

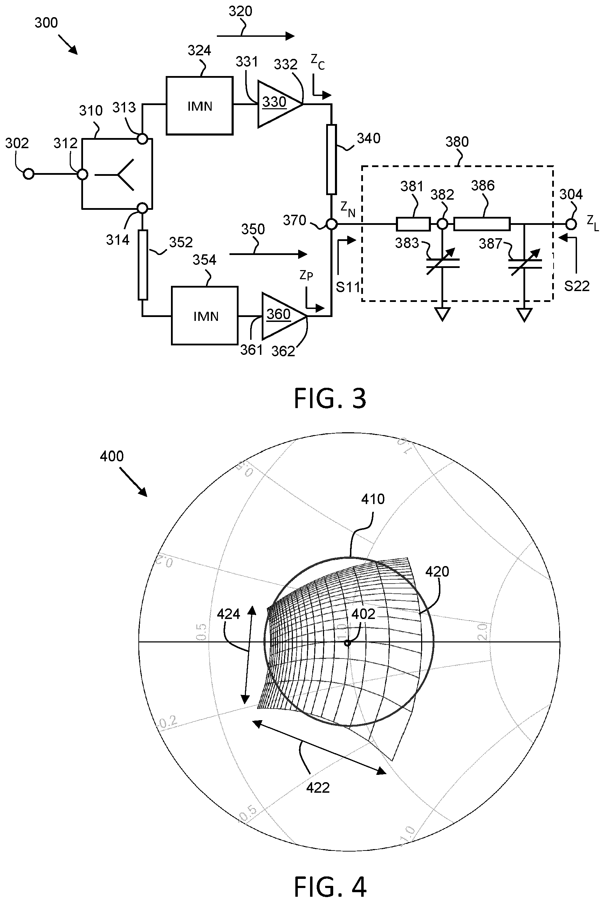

Embodiments of the inventive subject matter include a Doherty power amplifier with a reconfigurable output impedance transformer (e.g., impedance transformer 380, 680, 780, 880, 980, FIGs 3, 6-9) coupled between the combining node and RF output of the amplifier. The reconfigurable output impedance transformer is designed to transform a target range of load impedances to a target impedance at the combining node.

In one or more embodiments, the reconfigurable output impedance transformer includes a phase shift element (e.g., an inductor and/or a transmission line with a specific electrical length), a first variable capacitor, and a second variable capacitor. The phase shift element has an input end coupled to the combining node, and an output end coupled to the RF output. The first variable capacitor is coupled to the input end of the phase shift element, and the second variable capacitor is coupled to the output end of the phase shift element. By adjusting capacitance values of the first and second variable capacitors, the reconfigurable output impedance transformer can be tuned to provide a good impedance match between the combining node (e.g., characterized by an impedance between about 10 and 30 Ohms) and a load (e.g., characterized by an impedance between about 40 and 60 Ohms) that is coupled to the RF output.

In contrast with conventional Doherty amplifiers that have fixed output impedance transformers, including an embodiment of a reconfigurable output impedance transformer between the combining node and the RF output may provide any of several advantages. For example, having the ability to adjust the capacitance values of the reconfigurable output impedance transformer enables the Doherty amplifier to be adapted to a range of load impedances. By including two tunable capacitors separated by a phase shift element, a nearly orthogonal two-dimensional impedance tuning map may be implemented, which may cover substantially all phases of a target load VSWR (variable standing wave ratio). Further, the reconfigurable output impedance transformer may be designed with variable capacitors having relatively small capacitance tuning ratios. Further still, the reconfigurable output impedance transformer may be designed with a relatively small insertion loss. Accordingly, embodiments of Doherty power amplifiers disclosed herein may be capable of accommodating RF signals with high peak-to-average power ratios with potentially excellent RF performance (e.g., high gain, high efficiency, good linearity).

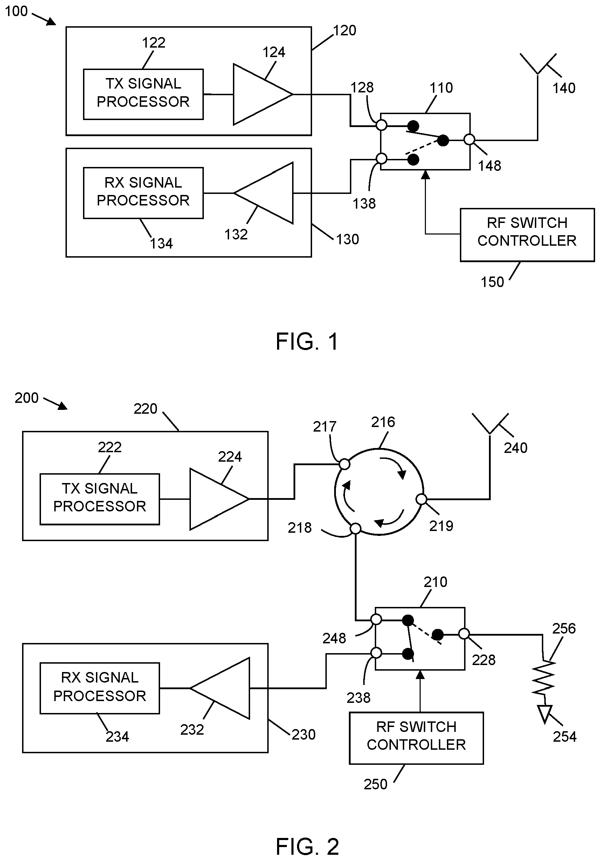

FIG. 1 is a simplified block diagram of an example of an RF transceiver system 100 that includes an RF switch 110, a transmitter 120, a receiver 130, an antenna 140, and an RF switch controller 150. Transceiver system 100 is a half-duplex transceiver, in which only one of the transmitter 120 or the receiver 130 are coupled, through the RF switch 110, to the antenna 140 at any given time. More specifically, the state of the RF switch 110 is controlled by RF switch controller 150 to alternate between coupling an RF transmit signal produced by the transmitter 120 to the antenna 140, or coupling an RF receive signal received by the antenna 140 to the receiver 130.

The transmitter 120 may include, for example, a transmit (TX) signal processor 122 and a power amplifier 124 (e.g., any of Doherty power amplifiers 300, 600, 700, 800, FIGs 3 and 6-8). The transmit signal processor 122 is configured to produce transmit signals, and to provide the transmit signals to the power amplifier 124. The power amplifier 124 amplifies the transmit signals, and provides the amplified transmit signals to the RF switch 110. The receiver 130 may include, for example, a receive amplifier 132 (e.g., a low noise amplifier) and a receive (RX) signal processor 134. The receive amplifier 132 is configured to amplify relatively low power received signals from the RF switch 110, and to provide the amplified received signals to the receive signal processor 134. The receive signal processor 134 is configured to consume or process the receive signals.

During each transmit time interval, when the transceiver 100 is in a "transmit mode," the RF switch controller 150 controls the RF switch 110 to be in a first or "transmit" state, as depicted in FIG. 1, in which a conductive transmit signal path is established between transmitter node 128 and antenna node 148, and in which a receive signal path is in a high impedance state (e.g., open circuit) between antenna node 148 and receiver node 138. Conversely, during each receive time interval, when the transceiver 100 is in a "receive mode," the RF switch controller 150 controls the RF switch 110 to be in a second or "receive" state, in which a conductive receive signal path, indicated by a dashed line in FIG. 1, is established between antenna node 148 and receiver node 138, and in which the transmit signal path is in a high impedance state (e.g., open circuit) between transmitter node 128 and antenna node 148.

FIG. 2 is a simplified block diagram of another example of RF transceiver system 200 that includes an RF switch 210, a circulator 216, a transmitter 220, a receiver 230, an antenna 240, and an RF switch controller 250. The transmitter 220 and the receiver 230 are coupled to the antenna 240 through the circulator 216. More specifically, the circulator 216 is a three-port device, with a first port 217 coupled to the transmitter 220, a second port 218 couplable to the receiver 230 through RF switch 210, and a third port 219 coupled to the antenna 240. The RF switch 210 also is a three-port device, with a first port 248 coupled to the receiver port 218 of the circulator 216, a second port 238 coupled to the receiver 230, and a third port 228 coupled to a ground reference node 254 through a resistor 256.

Again, the transmitter 220 may include, for example, a TX signal processor 222 and a power amplifier 224 (e.g., any of Doherty power amplifiers 300, 600, 700, 800, FIGs 3 and 6-8). The transmit signal processor 222 is configured to produce transmit signals, and to provide the transmit signals to the power amplifier 224. The power amplifier 224 amplifies the transmit signals, and provides the amplified transmit signals to the antenna 240 through the circulator 216. The receiver 230 may include, for example, a receive amplifier 232 (e.g., a low noise amplifier) and an RX signal processor 234. The receive amplifier 232 is configured to amplify relatively low power received signals received from the antenna 240 (through the circulator 216 and the RF switch 210), and to provide the amplified received signals to the receive signal processor 234. The receive signal processor 234 is configured to consume or process the receive signals.

The circulator 216 is characterized by a signal-conduction directivity, which is indicated by the arrows within the depiction of circulator 216. Essentially, RF signals may be conveyed between the circulator ports 217-219 in the indicated direction (counter-clockwise), and not in the opposite direction (clockwise). Accordingly, during normal operations, signals may be conveyed through the circulator 216 from transmitter port 217 to antenna port 219, and from antenna port 219 to receiver port 218, but not directly from transmitter port 217 to receiver port 218 or from receiver port 218 to antenna port 219.

In some situations, while the transceiver 200 is in the transmit mode, the circulator 216 may not be able to convey signal energy received through transmitter port 217 from the transmitter 220 to the antenna 240 through antenna port 219. For example, the antenna 240 may be disconnected from the antenna port 219, or may otherwise be in a very high impedance state. In such situations, the circulator 216 may convey signal energy from the transmitter 220 (i.e., signal energy received through transmitter port 217) past the antenna port 219 to the receiver port 218. To avoid conveying transmitter signal energy into the receiver 230 while the transceiver 200 is in the transmit mode, the RF switch controller 250 operates the RF switch 210 as a fail-safe switch by coupling the first port 248 to a ground reference node 254.

More specifically, when the transceiver 200 is in a receive mode, the RF switch 210 is controlled by RF switch controller 250 to be in a receive state, as shown in FIG. 2. In the receive state, the receiver port 218 of the circulator 216 is coupled through RF switch 210 to the receiver 230 (i.e., RF switch controller 250 configures RF switch 210 to have a conductive path between ports 248 and 238, and a high-impedance, open-circuit condition between ports 248 and 228). Conversely, when the transceiver 200 is in a transmit mode, the RF switch 210 is controlled by RF switch controller 250 to be in a transmit state, in which the receiver port 218 of the circulator 216 is coupled through the RF switch 210 to the ground termination 254 through resistor 256 (i.e., RF switch controller 250 configures RF switch 210 to have a conductive path, indicated by a dashed line in FIG. 2, between ports 248 and 228, and a high-impedance, open-circuit condition between ports 248 and 238). Accordingly, if the transmitter signal energy bypasses the antenna port 219 while the transceiver 200 is in the transmit mode, any signal energy that is conveyed through the receiver port 218 of the circulator 216 to the RF switch 210 will be shunted to the ground termination 254 through port 228 of the RF switch 210.

As indicated above, the transmit power amplifier (e.g., amplifier 124, 224, FIGs 1, 2) in a wireless transmitter (e.g., transmitter 120, 220, FIGs 1, 2) may be a Doherty power amplifier. According to one or more embodiments, the Doherty power amplifier may include a reconfigurable output impedance transformer (e.g., reconfigurable output impedance transformer 380, 680, 780, 880, FIGs 3, 6-8). As will be explained in more detail below, the reconfigurable output impedance transformer enables the Doherty power amplifier to be "tuned" to ensure good RF performance over a target range of load impedances.

For example, FIG. 3 illustrates a simplified schematic of a Doherty power amplifier 300, according to an embodiment. Doherty power amplifier 300 may be used in the transmitters 120, 220 of FIGs 1, 2, or in other types of RF transmitters.

Doherty power amplifier 300 includes an RF input 302, an RF output 304, a signal splitter 310, a carrier amplification path 320, a peaking amplification path 350, a combining node 370, and a reconfigurable output impedance transformer 380. The carrier amplification path 320 includes an input impedance matching network (IMN) 324, a carrier amplifier 330, and a phase shift and impedance inversion element 340. The peaking amplification path 350 includes a phase shift element 352, an input impedance matching network (IMN) 354, and a peaking amplifier 360.

Briefly, during operation of Doherty power amplifier 300, the power of an input RF signal provided at RF input 302 is divided by signal splitter 310 into carrier and peaking RF signals. The carrier RF signal is amplified along the carrier amplification path 320, and the peaking RF signal is amplified along the peaking amplification path 350. Generally, the carrier and peaking amplifiers 330, 360 are the primary active components that provide signal amplification along the carrier and peaking amplification paths 320, 350, respectively. The amplified carrier and peaking RF signals are combined at combining node 370, and conveyed through the reconfigurable output impedance transformer 380 to the RF output 304.

When incorporated into a larger system (e.g., a wireless communication system), a load is coupled to the RF output 304. For example, as discussed in conjunction with FIGs 1 and 2, the load may include an RF switch (e.g., RF switch 110, FIG. 1) and an antenna (e.g., antenna 140, FIG. 1). Alternatively, the load may include a circulator (e.g., circulator 216, FIG. 2) and an antenna (e.g., antenna 240, FIG. 2), or another type of load. Either way, the load is characterized by a load impedance, which is indicated in FIG. 3 as *Z_{L}* at RF output 304. It should be noted here that the impedance, *Z_{N}*, at the combining node 370 is not equal to the load impedance, *Z_{L}.* Generally, the combining node impedance, *Z_{N}*, is dependent on the amplifier power, transistor technology, and drain voltage. During operation of the Doherty power amplifier 300, the reconfigurable output impedance transformer 380 is configured to transform the load impedance, *Z_{L},* at output 304 to the impedance, *Z_{N}*, at combining node 370.

Doherty power amplifier 300 is considered to be a "two-way" Doherty power amplifier, which includes one carrier amplification path 320 and one peaking amplification path 350. In other embodiments, Doherty power amplifier 300 may include one or more additional peaking amplification paths (not shown) in parallel with peaking amplification path 350.

Further, in various embodiments, Doherty power amplifier 300 may be a "symmetric" or an "asymmetric" amplifier. When Doherty power amplifier 300 is a "symmetric" amplifier, the relative sizes of the carrier and peaking power amplifiers 330, 360 are approximately equal to each other. Conversely, when Doherty power amplifier 300 is an "asymmetric" amplifier, the relative sizes of the carrier and peaking power amplifiers 330, 360 are different from each other. Typically, in an asymmetric Doherty power amplifier, the peaking power amplifier 360 is larger than the carrier power amplifier 330.

More specifically, as used herein, the term "size", when referring to a physical characteristic of a power amplifier or power transistor, refers to the periphery or the current carrying capacity of the transistor(s) associated with that amplifier or transistor. The term "symmetric", when referring to the relative sizes of carrier and peaking amplifiers 330 and 360, means that the size of the power transistor(s) forming the carrier amplifier 330 is/are substantially identical to (i.e., within 5%) the size of the power transistor(s) forming the peaking amplifier 360. Conversely, the term "asymmetric" means that the size of the power transistor(s) forming the carrier amplifier 330 is/are significantly different from the size of the power transistor(s) forming the peaking amplifier 360 (e.g., the size of the power transistor(s) forming the peaking amplifier 360 is/are from 50% to 100% or more than the size of the power transistor(s) forming the carrier amplifier). Accordingly, for example, when the ratio of carrier amplifier size to peaking amplifier size (or the "carrier-to-peaking ratio") is denoted as x:y (where x corresponds to relative carrier amplifier size and y corresponds to relative peaking amplifier size), a ratio of 1:1 would be symmetric, and a ratio of 1:2 would be asymmetric, according to the above definitions.

The configuration of Doherty power amplifier 300 will now be discussed in more detail. The RF input 302 is configured to receive an input RF signal (e.g., from TX signal processor 122, 222, FIGs 1, 2), and to provide the input RF signal to the signal splitter 310.

The signal splitter 310 may have any of a variety of configurations. For example, signal splitter 310 may be a splitter selected from a Wilkinson-type splitter, a hybrid quadrature splitter, or another suitable type of splitter. Either way, the signal splitter 310 has an input 312 coupled to the RF input 302, and two outputs 313, 314. A first signal splitter output 313 is coupled to the carrier amplification path 320, and a second signal splitter output 314 is coupled to the peaking amplification path 350. The signal splitter 310 is configured to receive, at input 312, an input RF signal from RF input 302, and to divide the power of the input RF signal into a carrier input RF signal and a peaking RF input signal. The signal splitter 310 is further configured to provide, at the first signal splitter output 313, the carrier input RF signal to the carrier amplification path 320, and to provide, at the second signal splitter output 314, the peaking input RF signal to the peaking amplification path 350.

During operation of amplifier 300 in a relatively low-power mode (i.e., when the power of the input RF signal is below a threshold), only the carrier amplification path 320 supplies current to the load (through RF output 304). In such circumstances, the RF signal level at the peaking amplifier input 361, is below the threshold to turn on the peaking amplifier 360. Thus, the combined power from the carrier and peaking amplifiers 330, 360 is substantially from the carrier amplification path 320. Conversely, during operation of amplifier 300 in a relatively high-power mode (i.e., when the power of the input RF signal is above a threshold), both the carrier and peaking amplification paths 320, 350 supply current to the load (through RF output 304). In such circumstances, the RF signal level at the peaking amplifier input 361 is above the threshold to turn on the peaking amplifier 360. Thus, both the carrier and peaking amplifier paths 320, 350 contribute to the combined power.

The signal splitter 310 divides the power of the input RF signal according to a carrier-to-peaking size ratio. For example, when Doherty power amplifier 300 has a symmetric configuration in which the carrier amplifier 330 and the peaking amplifier 360 are substantially equal in size (i.e., the Doherty power amplifier 300 has a 1:1 carrier-to-peaking size ratio), the signal splitter 310 may divide the power of the input RF signal such that about half of the input RF signal power is provided to the carrier amplification path 320, and about half of the input RF signal power is provided to the peaking amplification path 350. Conversely, when Doherty power amplifier 300 has an asymmetric configuration (e.g., the Doherty power amplifier 300 has a 1:*x* carrier-to-peaking size ratio, where x > 1), the signal splitter 310 may divide the power unequally. For example, when Doherty power amplifier 300 has a 1:2 carrier-to-peaking size ratio, signal splitter 310 may divide the power of the input RF signal such that a third of the input signal power is provided to the carrier amplification path 320, and two thirds of the input signal power is provided to the peaking amplification path 350.

The carrier amplification path 320 is coupled between the first splitter output 313 and the combining node 370. The carrier amplification path 320 includes a carrier input matching network (IMN) 334, the carrier amplifier 330, and a phase shift and impedance inversion element 340. The carrier IMN 324 is configured to incrementally increase the circuit impedance. For example, but not by way of limitation, the carrier IMN 324 may include, for example, a lowpass or bandpass circuit configured as a T- or pi- impedance matching network.

The carrier amplifier 330 has a carrier amplifier input 331 (e.g., a gate terminal) and two current-carrying terminals (e.g., drain and source terminals). The carrier amplifier input 331 is coupled to the carrier IMN 324. One of the current-carrying terminals (e.g., the drain terminal) of the carrier amplifier 330 functions as a carrier amplifier output 332, at which an amplified carrier signal is produced by the carrier amplifier 330. The other current-carrying terminal (e.g., the source terminal) of the carrier amplifier 330 may be coupled to a ground reference node.

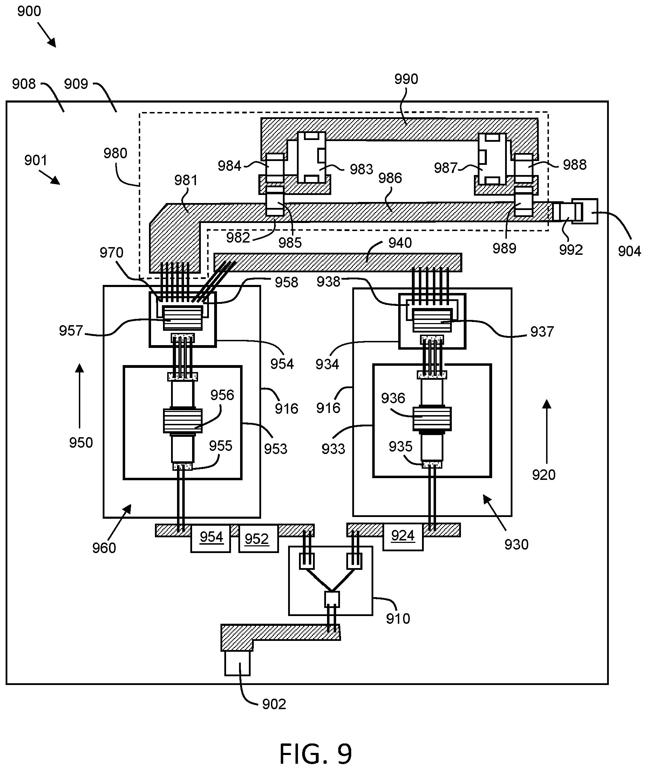

The carrier amplifier 330 may include a single-stage amplifier (i.e., an amplifier with a single amplification stage or power transistor). In other embodiments, the carrier amplifier 330 may include a two-stage amplifier, which includes a relatively low-power driver amplifier (e.g., amplifier 936, FIG. 9) and a relatively high-power final-stage amplifier (e.g., amplifier 937, FIG. 9) connected in a cascade (or series) arrangement between the carrier amplifier input and the carrier amplifier output. In the carrier amplifier cascade arrangement, an output (e.g., drain terminal) of the driver amplifier is electrically coupled to an input (e.g., gate terminal) of the final-stage amplifier.

The output 332 (e.g., drain terminal) of the carrier amplifier 330 is electrically coupled through the phase shift and impedance inversion element 340 to the combining node 370. The output 332 of the carrier amplifier 330 is characterized by an impedance, Ze.

According to an embodiment, the phase shift and impedance inversion element 340 is configured to apply a phase shift to the amplified carrier signal, and also to supply an impedance inversion to ensure proper Doherty amplifier operation. For example, the phase shift and impedance inversion element 340 may include a transmission line and one or more passive electrical components that produce the desired phase shift and impedance inversion. According to one or more embodiments, the phase shift and impedance inversion element 340, may have an electrical length of about 90 degrees.

The peaking amplification path 350 is coupled between the second splitter output 314 and the combining node 370. The peaking amplification path 350 includes a phase shift element 352, a peaking IMN 354, and the peaking amplifier 360.

As a governing rule, the electrical length of the carrier amplification path 320 should equal the electrical length of the peaking amplification path 350. Accordingly, the phase shift element 352 is configured to compensate for the phase shift applied along the carrier amplification path 320 (e.g., by phase shift and impedance inversion element 340), to ensure that the amplified carrier and peaking signals arrive in phase at the combining node 370. For example the phase shift element 352 may include a transmission line and/or various passive components that are configured to apply a specific phase shift to the peaking signal that results in in-phase combining of the carrier and peaking signals at the combining node 370. For example, the phase shift element 352 may include a transmission line and one or more passive electrical components that produce the desired phase shift. According to one or more embodiments, the phase shift element 352, may have an electrical length of about 90 degrees.

The peaking IMN 354 is configured to incrementally increase the circuit impedance. For example, but not by way of limitation, the peaking IMN 354 may include, for example, a lowpass or bandpass circuit configured as a T- or pi- impedance matching network.

The peaking amplifier 360 has a peaking amplifier input 361 (e.g., a gate terminal) and two current-carrying terminals (e.g., drain and source terminals). The peaking amplifier input 361 is coupled to the peaking IMN 354. One of the current-carrying terminals (e.g., the drain terminal) of the peaking amplifier 360 functions as a peaking amplifier output 362, at which an amplified peaking signal is produced by the peaking amplifier 360. The other current-carrying terminal (e.g., the source terminal) of the peaking amplifier 360 may be coupled to a ground reference node.

The peaking amplifier 360 may include a single-stage amplifier (i.e., an amplifier with a single amplification stage or power transistor). In other embodiments, the peaking amplifier 360 may include a two-stage amplifier, which includes a relatively low-power driver amplifier (e.g., amplifier 956, FIG. 9) and a relatively high-power final-stage amplifier (e.g., amplifier 957, FIG. 9) connected in a cascade (or series) arrangement between the peaking amplifier input and the peaking amplifier output. In the peaking amplifier cascade arrangement, an output (e.g., drain terminal) of the driver amplifier is electrically coupled to an input (e.g., gate terminal) of the final-stage amplifier.

The output 362 (e.g., drain terminal) of the peaking amplifier 360 is electrically coupled to the combining node 370. The combining node 370 is configured to combine the amplified carrier signal and the amplified peaking signal to produce a combined amplified signal. The output 362 of the peaking amplifier 360 is characterized by an impedance, *Z_{P}*.

Although not shown in FIG. 3, various DC bias circuits are coupled to the inputs 331, 361 and to the outputs 332, 362 of the carrier and peaking amplifiers 330, 360, in order to convey DC bias voltages that will ensure proper operation of the Doherty power amplifier 300. More specifically, during operation of Doherty power amplifier 300, the carrier amplifier 330 is biased to operate in class AB mode or deep class AB mode, and the peaking amplifier 360 is biased to operate in class C mode or deep class C mode.

At low to moderate input signal power levels (i.e., where the power of the input signal at RF input 302 is lower than the turn-on threshold level of peaking amplifier 360), the Doherty power amplifier 300 operates in a low-power mode in which the carrier amplifier 330 operates to amplify the input signal, and the peaking amplifier 360 is minimally conducting (e.g., the peaking amplifier 360 essentially is in an off state). Conversely, as the input signal power increases to a level at which the carrier amplifier 330 reaches voltage saturation, the signal splitter 310 divides the energy of the input signal between the carrier and peaking amplifier paths 320, 350, and both amplifiers 330, 360 operate to amplify their respective portion of the input signal.

As the input signal level increases beyond the point at which the carrier amplifier 330 is operating in compression, the peaking amplifier 360 conduction also increases, thus supplying more current to the reconfigurable output impedance transformer 380 and the load. In response, the load line impedance of the carrier amplifier output decreases. In fact, an impedance modulation effect occurs in which the load line of the carrier amplifier 330 changes dynamically in response to the input signal power (i.e., the peaking amplifier 360 provides active load pulling to the carrier amplifier 330). The phase shift and impedance inversion element 340, transforms the carrier amplifier load line impedance to a high value at backoff, allowing the carrier amplifier 330 to efficiently supply power to the reconfigurable output impedance transformer 380 and the load over an extended output power range.

As mentioned above, the impedance, *Z_{N}*, at the combining node 370 typically is not equal to the load impedance, *Z_{L},* at the RF output 304. The reconfigurable output impedance transformer 380 functions to transform the load impedance, *Z_{L},* at output 304 to the combining node impedance, *Z_{N}*, at the combining node 370. In addition, transformer 380 has the ability to be reconfigured to reduce the impedance variation (e.g., from -14 dB return loss to -35 dB return loss), as will be discussed below.

The design of the Doherty power amplifier 300 may be optimized for operation with a load that has a particular nominal load impedance (e.g., 50 Ohms or some other value at the RF output 304). However, the actual load impedance, *Z_{L},* at output 304 may vary significantly (e.g., as a function of antenna impedance, filter impedance, circulator impedance, circuit board layout, and so on). During operation of the Doherty power amplifier 300, the reconfigurable output impedance transformer 380 is configured to transform a target range of load impedances, *Z_{L},* at output 304 to a target impedance, *Z_{N}*, at combining node 370.

According to one or more embodiments, the reconfigurable output impedance transformer 380 is configured to transform a load impedance, *Z_{L},* at the output 304 to a combining node impedance, *Z_{N}*, at the combining node 370 that may be half or less of the load impedance, *Z_{L}.* For example, the load impedance, *Z_{L},* typically may be in a range of about 40 Ohms to about 60 Ohms (e.g., about 50 Ohms), and the combining node impedance, *Z_{N}*, may be in a range of about 10 Ohms to about 30 Ohms (e.g., about 12 Ohms or about 20 Ohms), although the load impedance and/or the combining node impedance may be lower or higher, as well. In some embodiments, the reconfigurable output impedance transformer 380 may be configured to transform the load impedance, *Z_{L},* at the output 304 to a combining node impedance, *Z_{N}*, at the combining node 370 that is greater than half of the load impedance, *Z_{L}.* In some cases, *Z_{N}* could be greater than 50 Ohms.

Conventional Doherty power amplifiers have fixed output transformers that are optimized for a specific load impedance (e.g., 50 Ohms). When an actual load has a load impedance that is equal to the load impedance for which the Doherty power amplifier was designed, the Doherty power amplifier may experience its best RF performance. However, when the actual load has a load impedance that is different from the load impedance for which the Doherty power amplifier was designed, the RF performance may be impaired for a conventional Doherty power amplifier. In some systems, an impedance tuner may be inserted between a Doherty power amplifier output and a load in order to correct the impedance so that the amplifier sees 50 Ohms. However, such impedance tuners are characterized by relatively high insertion losses (e.g., > 0.3 dB), which diminishes the RF performance. Further, such impedance tuners do not form part of an output transformer.

In contrast, according to one or more embodiments, the reconfigurable output impedance transformer 380 includes fixed and variable components, which enable the transformer 380 to transform a range of load impedances to the impedance at the combining node 370 without significant insertion losses. More specifically, the reconfigurable output impedance transformer 380 includes first and second phase shift elements 381, 386 coupled in series between the combining node 370 and the RF output 304, with an intermediate node 382 between the first and second phase shift elements 381, 386. In addition, the reconfigurable output impedance transformer 380 includes a first variable capacitor 383 (or capacitor network) coupled in a shunt configuration between the intermediate node 382 and a ground reference node, and a second variable capacitor 387 (or capacitor network) coupled in a shunt configuration between the RF output 304 and the ground reference node. More specifically, a first terminal of the first variable capacitor 383 is coupled to (e.g., indirectly or directly connected to) the intermediate node 382 (i.e., to the output end of phase shift element 381 and to the input end of phase shift element 386), and a second terminal of the first variable capacitor 383 is coupled to (e.g., indirectly or directly connected to) the ground reference node. Similarly, a first terminal of the second variable capacitor 387 is coupled to (e.g., indirectly or directly connected to) the RF output 304 (i.e., to the output end of phase shift element 386), and a second terminal of the second variable capacitor 387 is coupled to (e.g., indirectly or directly connected to) the ground reference node.

As used herein, the term "shunt" means electrically coupled between a circuit node and a ground reference node (or other DC voltage reference). The ground reference node may be, for example, a conductive feature of the physical implementation of the Doherty power amplifier 300 that is configured to be coupled to system ground.

Each of the first and second phase shift elements 381, 386 may include a transmission line segment and/or an inductor. The first phase shift element 381 is characterized by a first impedance, *Z₁*, and a first phase shift, *θ₁*, between the combining node 370 and the intermediate node 382 (or between input and output ends of element 381) at the center frequency of operation, *f₀,* of the amplifier 300. The second phase shift element 386 is characterized by a second impedance, *Z₂*, and a second phase shift, *θ*₂, between the intermediate node 382 and the RF output 304 (or between input and output ends of element 386) at the center frequency of operation, *f₀*, of the amplifier 300. According to one or more embodiments, the first impedance, *Z₁*, may be in a range of about 20 to about 100, and the second impedance, *Z₂*, may be in a range of about 20 to about 100. The first and second phase shifts, *θ₁* and *θ*₂, correspond to first and second electrical lengths (between the input and output ends) of the phase shift elements 381, 386 at the fundamental frequency of operation, *f₀.* According to an embodiment, the first phase shift, *θ₁,* may be in a range of about 0 degrees to about 15 degrees, and the second phase shift, *θ*₂, may be in a range of about 15 degrees to about 45 degrees.

Each of the first variable capacitor 383 and the second variable capacitor 387 may be implemented with a tunable capacitor, such as but not by way of limitation, a voltage-controlled variable capacitor (VVAC), a digitally-controlled variable capacitor (DVC) (also known as a digitally-programmable capacitor or a digitally-tunable capacitor), a fuse-programmable capacitor bank, or another suitable tunable/variable capacitor. The capacitance values of the first and second variable capacitors 383, 387 may be adjusted by performing an appropriate tuning process. For example, a VVAC is a component with a capacitance value between first and second terminals that can be varied according to a control voltage applied to a tuning input (not shown). A DVC is a component with a capacitance value between first and second terminals that can be varied based on a digital value that is programmed (e.g., via a serial interface, not shown) into a digital register of the DVC. The DVC may be implemented with an array of switched capacitors, for example. The RF switches in the DVC may be semiconductor switches, such as gallium arsenide (GaAs), gallium nitride (GaN), or silicon-on-insulator (SOI) switches, or alternatively the RF switches may be switch devices that use phase change materials (PCM), such as germanium telluride (GeTe) or germanium-antimony-tellurium (GeSbTe). Any other suitable RF switch technology alternatively may be used. Finally, a fuse-programmable capacitor bank is a component that includes a network of capacitors and fuses (not shown), and adjusting the capacitance values includes blowing certain ones of the fuses to achieve desired capacitance values.

Regardless of the type of variable capacitor used for the first and second variable capacitors 383, 387, each of the variable capacitors 383, 387 is characterized by a capacitance tuning range and a corresponding capacitance tuning ratio. The capacitance tuning range specifies a range of capacitances (between an minimum capacitance and a maximum capacitance) that each variable capacitor 383, 387 may provide, and the capacitance tuning ratio corresponds to a ratio of the maximum capacitance to the minimum capacitance. For example, the first variable capacitor 383 has a capacitance tuning range between a minimum capacitance, *C_{MIN1},* and a maximum capacitance, *C_{MAX1},* with a capacitance tuning ratio of *C_{MAX1}*/*C_{MIN1}.* Similarly, the second variable capacitor 387 has a capacitance tuning range between a minimum capacitance, *C_{MIN2},* and a maximum capacitance, *C_{MAX2},* with a capacitance tuning ratio of *C_{MAX2}*/*C_{MIN2}.* Generally, a variable capacitor with a relatively small capacitance tuning ratio (e.g., 5.0 or less) may have lower insertion loss or may be smaller and less expensive than a variable capacitor with a relatively large capacitance range (e.g., 8 or more). Accordingly, it may be desirable to configure the reconfigurable output impedance transformer 380 so that the targeted tunable impedance range of the reconfigurable output impedance transformer 380 can be achieved with capacitance tuning ratios of the first and second variable capacitors 383, 387 that are relatively small.

In one or more embodiments, each of the first and second variable capacitors 383, 387 may be tuned to a plurality of discrete capacitance values between their minimum and maximum capacitance values. In other words, each of the first and second variable capacitors 383, 387 may have a predetermined number of distinct tuning states. For example, each of the first and second variable capacitors 383, 387 may have between 8 and 32 distinct tuning states (capacitance values), in some embodiments. In other embodiments, each of the first and second variable capacitors 383, 387 may have fewer or more distinct tuning states, or each of the first and second variable capacitors 383, 387 may be continuously variable to any capacitance value between their minimum and maximum capacitances.

The range of impedances across which the transformer 380 can tune is related to the capacitance tuning ranges for capacitors 383, 387 and the phase shift, *θ*₂, associated with the second phase shift element 386. When properly selected, the two variable capacitors 383, 387, separated by the second phase shift, *θ*₂, may enable adequate compensation for load gamma variations over a full 360 degrees of reflection coefficient. According to one or more embodiments, the characteristic phase shift, *θ*₂, of the second phase shift element 386 is selected such that, as the capacitance values of the two variable capacitors 383, 387 are adjusted, they tune in an approximately orthogonal fashion to map out a desired range of impedances. According to one or more embodiments, and as mentioned above, the phase shift, *θ*₂, associated with the phase shift element 386 may be selected to be in a range of about 15 degrees to about 45 degrees. Further, selection of a phase shift element 386 with a phase shift, *θ*₂, in a narrower range of about 25 degrees to about 35 degrees may result in nearly orthogonal tuning adjustability with the variable capacitors 383, 387.

To illustrate, reference is now made to FIG. 4, which is a Smith chart 400 showing a load reflection coefficient (or S22 or gamma) tuning map for a reconfigurable output impedance transformer (e.g., reconfigurable transformer 380, FIG. 3) with a second phase shift element (e.g., element 386, FIG. 3) that is characterized by a phase shift, *θ*₂, of approximately 30 degrees. The Smith chart 400 is normalized to the load impedance, *Z_{L}*, (i.e., a center 402 of the Smith chart 400 corresponds to the load impedance, *Z_{L}*).

According to one or more embodiments, the reconfigurable output impedance transformer 380 is designed to accommodate load impedances, *Z_{L},* with reflection coefficients (S22) of up to 0.2 (approximately - 14 dB return loss), which may be corrected over a full 360 degrees of reflection coefficient to return losses (S 1 1) of about -35 dB return loss or less. In Smith chart 400, the target reflection coefficient range (gamma range) of 0.2 is indicated with a target gamma circle 410.

The impedance adjustment is achieved by adjusting the capacitance values of the variable capacitors (e.g., capacitors 383, 387, FIG. 3). A grid 420 overlying the target gamma circle 410 indicates a range of load impedances, *Z_{L},* over which the reconfigurable output impedance transformer 380 can be adjusted to transform the load impedances, *Z_{L},* to the combining node impedance, Z*_{N}.* In the grid 420, the 16 roughly vertical impedance arcs correspond to 16 distinct tuning states (capacitance values) for the first variable capacitor (e.g., capacitor 383, FIG. 3), and the 16 roughly horizontal impedance arcs correspond to 16 distinct tuning states (capacitance values) for the second variable capacitor (e.g., capacitor 387, FIG. 3). In other words, grid 420 reflects the tunability when the first and second variable capacitors (e.g., capacitors 383, 387, FIG. 3) each have 16 tuning states (i.e., each capacitor 383, 387 is tunable to any of 16 distinct capacitance values).

To adjust a given load impedance, *Z_{L},* that falls anywhere within the target gamma circle 410 toward the combining node impedance, *Z_{N}*, the capacitance value of the first variable capacitor (e.g., capacitor 383, FIG. 3) may be adjusted to move the impedance in a desired direction along a horizontal arc (e.g., as indicated by arrow 422), and the capacitance value of the second variable capacitor (e.g., capacitor 387, FIG. 3) may be adjusted to move the impedance in a desired direction along a vertical arc (e.g., as indicated by arrow 424).

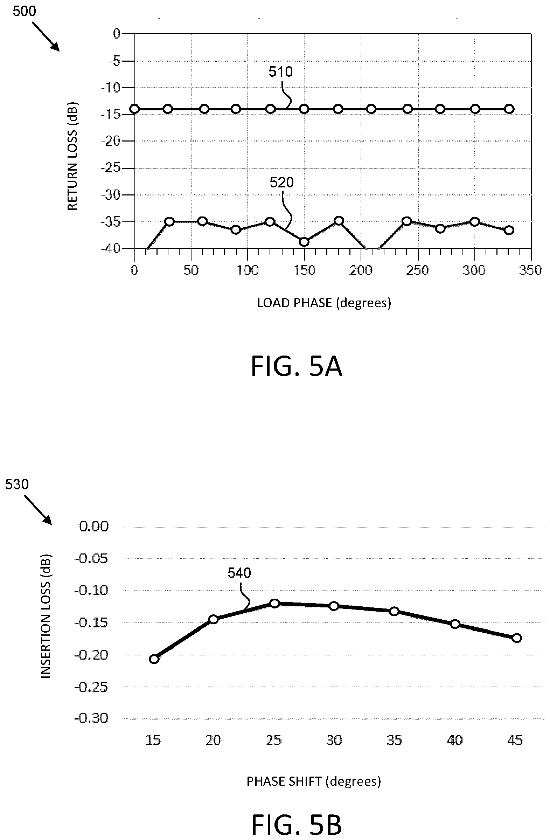

The magnitude of the impedance correction may be further visualized with reference to FIG. 5A, which is a chart 500 that depicts loadpull results for a transformer (e.g., transformer 380, FIG. 3) with a load impedance, *Z_{L},* of about 50 Ohms, and a combining node impedance, *Z_{N}*, of about 12 Ohms. The loadpull was conducted with a gamma of about 0.2 for all phases, and the capacitance values of the first and second variable capacitors (e.g., capacitors 383, 387, FIG. 3) were swept over the range required to achieve an input return loss at the combining node 370 of less than about -35 dB for each load phase. In chart 500, a first plot 510 corresponds to the return loss of a load with gamma of 0.2 and an associated load return loss of about -14 dB (S 1 1) (vertical axis) over a full 360 degrees of reflection coefficient (horizontal axis). A second plot 520 shows that optimized selection of the capacitance values of the first and second variable capacitors (e.g., capacitors 383, 387, FIG. 3) for each load phase enables correction to a much lower input return loss of about -35 dB or less for a combining node (e.g., node 370, FIG. 3) with an impedance of about 12 Ohms.

As indicated in FIG. 5A, embodiments of a reconfigurable output impedance transformer 380 enable a fairly high load return loss (e.g., about -14 dB) to be corrected to a significantly lower input return loss (e.g., < -35 dB), simply by adjusting the capacitance values of the capacitors within a reconfigurable output impedance transformer (e.g., by adjusting the capacitance of the first and second variable capacitors 383, 387, FIG. 3). Further, the nearly orthogonal tuning adjustability that may be made possible by selecting an appropriate phase shift, *θ*₂ , for the phase shift element 386 enables selection of variable capacitors 383, 387 with relatively small capacitance tuning ratios (e.g., < 5.0).

Various embodiments of reconfigurable output impedance transformer 380 are configured to transform any load impedance, *Z_{L},* that is within -14dB return loss from the nominal load impedance of 50 Ohms, to a combining load impedance, *Z_{N}*, that is within -35dB return loss of the targeted nominal combining node impedance of 12 Ohms. As discussed above, in order to reduce the impedance variation (e.g., from -14dB return loss to -35dB return loss) using the first and second variable capacitors 383, 387 (FIG. 3), a certain amount of capacitive tuning ratio is needed. As also discussed above, it may be desirable to configure the reconfigurable output impedance transformer 380 so that the targeted tunable impedance range of the reconfigurable output impedance transformer 380 can be achieved with capacitance tuning ratios of the first and second variable capacitors 383, 387 that are relatively small.

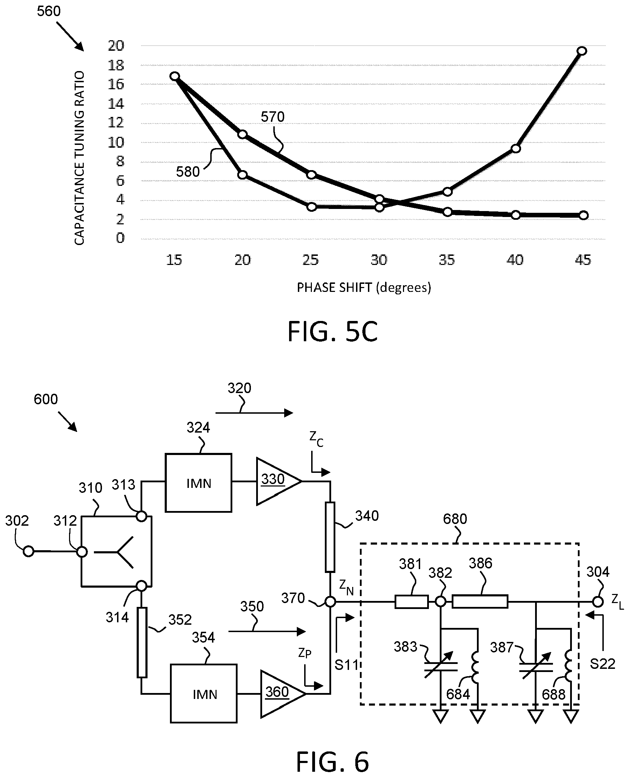

To illustrate, FIG. 5B is a chart 530 that plots the dependence of insertion loss (vertical axis) on the phase shift, *θ*₂, associated with the phase shift element 386 (horizontal axis). Further, FIG. 5C is a chart 560 that plots capacitance tuning ratio (vertical axis) of the first and second variable capacitors 383, 387 versus phase shift, *θ*₂. Each of FIGs 5B and 5C correspond to an example embodiment of a Doherty power amplifier (e.g., amplifier 300, FIG. 3) that is designed to operate at a fundamental frequency, *f0*, of about 3.6 gigahertz (GHz).

The relationships between phase shift, insertion loss, and capacitance tuning ratio requirements that are indicated in FIGs 5B and 5C are summarized in the following table:

| phase shift (deg) | Insertion Loss (dB) | C 383 Tuning Ratio | C 387 Tuning Ratio |
|---|---|---|---|
| 15 | -0.21 | 16.8 | 16.9 |
| 20 | -0.14 | 10.7 | 6.6 |
| 25 | -0.12 | 6.6 | 3.3 |
| 30 | -0.12 | 4.05 | 3.2 |
| 35 | -0.13 | 2.79 | 4.79 |
| 40 | -0.15 | 2.545 | 9.28 |
| 45 | -0.17 | 2.38 | 19.43 |

In chart 530 (FIG. 5B), trace 540 correlates insertion loss with the phase shift, *θ*₂, associated with the phase shift element 386. As mentioned above, the phase shift, *θ*₂, associated with the phase shift element 386 desirably may be selected to be in a range of about 15 degrees to about 45 degrees. Further, selection of a phase shift element 386 with a phase shift, *θ*₂, in a narrower range of about 25 degrees to about 35 degrees may result in a relatively low return loss (e.g., about -0.14 dB or less), and nearly orthogonal tuning adjustability with the variable capacitors 383, 387. Accordingly, including a phase shift element 386 with a phase shift within this range may be desirable.

Chart 560 (FIG. 5C) indicates required capacitance tuning ratios for the first and second variable capacitors 383, 387, to meet the performance indicated in FIG. 5A. This indicates that relatively small required capacitance tuning ratios may be achievable for both capacitors 383, 387 when a phase shift, , *θ*₂, is chosen with a value between about 25 degrees to about 35 degrees. In chart 560, plot 570 corresponds to the tuning ratio versus phase shift for the first variable capacitor 383, and plot 580 corresponds to the tuning ratio versus phase shift for the second variable capacitor 387. Referring first to plot 570, and when the phase shift element 386 is designed to have a phase shift, *θ*₂, of about 30 degrees, the first variable capacitor 383 may be selected to have a minimum capacitance, *C_{MIN1},* of about 0.47 picofarads (pF) and a maximum capacitance, *C_{MAX1},* of about 1.77 pF, which corresponds to a relatively-small capacitance tuning ratio, *C_{MAX1}*/*C_{MIN1},* of about 4.05. Additionally, and referring to plot 580, the second variable capacitor 387 may be selected to have a minimum capacitance, *C_{MIN2},* of about 0.30 pF and a maximum capacitance, *C_{MAX2},* of about 0.95 pF, which corresponds to a relatively-small capacitance tuning ratio, *C_{MAX2}*/*C_{MIN2},* of about 3.20. It should be noted here that the capacitance ranges of the first and second variable capacitors 383, 387 may be different for different fundamental frequencies of operation and for different transformer impedances, *Z_{L},* and *Z_{N}.* Enabling a selection of capacitors with relatively small capacitance tuning ratios through an appropriate selection of the second phase shift, *θ*₂, may enable the insertion loss, size, and/or cost of the tunable capacitors and the reconfigurable output impedance transformer 380 to be minimized.

FIG. 3 depicts a reconfigurable output impedance transformer 380 with two shunt variable capacitors 383, 387. In some cases, it may be desired to increase the effective tuning range beyond a range that is achievable with the two shunt capacitors 383, 387. One such case is when the tuning range of the tunable capacitor is insufficient meet the impedance tuning range target of the reconfigurable output impedance transformer 380. FIG. 6 illustrates an embodiment of a Doherty power amplifier 600 with a reconfigurable output impedance transformer 680 that may provide an increased tuning range by including a shunt impedance 684, 688 in parallel with each of the variable capacitors 383, 387.

As with amplifier 300 (FIG. 3), Doherty power amplifier 600 includes an RF input 302, an RF output 304, a signal splitter 310, a carrier amplification path 320, a peaking amplification path 350, and a combining node 370. The carrier amplification path 320 includes a first input IMN 324, a carrier amplifier 330, and a phase shift and impedance inversion element 340. The peaking amplification path 350 includes a phase shift element 352, a second input IMN 354, and a peaking amplifier 360. Each of the above-listed components may be substantially identical to their same-numbered components in FIG. 3, and all details described above for those components are intended to be incorporated into this description of FIG. 6.

The differences between Doherty power amplifier 300 and Doherty power amplifier 600 may be found in the configurations of the reconfigurable output impedance transformers 380, 680. Both reconfigurable transformers 380, 680 include first and second phase shift elements 381, 386 coupled in series between the combining node 370 and the RF output 304, with an intermediate node 382 between the first and second phase shift elements 381, 386. In addition, both of the reconfigurable output impedance transformers 380, 680 include a first variable capacitor 383 (or capacitor network) coupled in a shunt configuration between the intermediate node 382 and a ground reference node, and a second variable capacitor 387 (or capacitor network) coupled in a shunt configuration between the RF output 304 and the ground reference node. Again, each of the above-listed components may be substantially identical to their same-numbered components in FIG. 3, and all details described above for those components are intended to be incorporated into this description of FIG. 6.

As mentioned above, the reconfigurable output impedance transformer 680 differs from the reconfigurable output impedance transformer 380 (FIG. 3) by including a first shunt inductor 684 in parallel with the first variable capacitor 383, and by including a second shunt inductor 688 in parallel with the second variable capacitor 387. The first shunt inductor 684 has a first terminal coupled to (e.g., indirectly or directly connected to) the first terminal of variable capacitor 383 and to the intermediate node 382 (i.e., to the output end of element 381 and to the input end of element 386), and a second terminal coupled to (e.g., indirectly or directly connected to) the ground reference node. The second shunt inductor 688 has a first terminal coupled to (e.g., indirectly or directly connected to) the first terminal of variable capacitor 387 and to the RF output 304 (i.e., to the output end of element 386), and a second terminal coupled to (e.g., indirectly or directly connected to) the ground reference node. In various embodiments, the first and second shunt inductors 684, 688 may be implemented with discrete surface-mount components, printed coils, wirebonds, or combinations thereof.

In accordance with the above-given example, when the Doherty power amplifier 600 is designed to operate at a fundamental frequency, *f0*, of about 3.6 GHz, when the phase shift element 386 is designed to have a phase shift, *θ*₂, of about 30 degrees, and when the first and second variable capacitors 383, 387 are designed to have a reconfigurable capacitance value in ranges of about 0.47 pF to about 1.77 pF or about 0.30 pF to about 0.95 pF, respectively, the first shunt inductor 684 may be selected to have an inductance in a range of about 2 nanohenries (nH) to about 20 nH, and the second shunt inductor 688 may be selected to have an inductance in a range of about 2 nH to about 20 nH. It should be noted here that the inductance ranges of the first and second inductors 684, 688 may be different for different fundamental frequencies of operation.

When the reconfigurable output impedance transformers 380, 680 are compared, it may be apparent that the parallel combination of the first variable capacitor 383 and the first shunt inductor 684 may have an increased tuning range, and the parallel combination of the second variable capacitor 387 and the second shunt inductor 688 may have an increased tuning range. The configuration shown in FIG. 6 may be particularly desired when the capacitance tuning ranges of the first and second variable capacitors 383, 387 is less than desired or required.

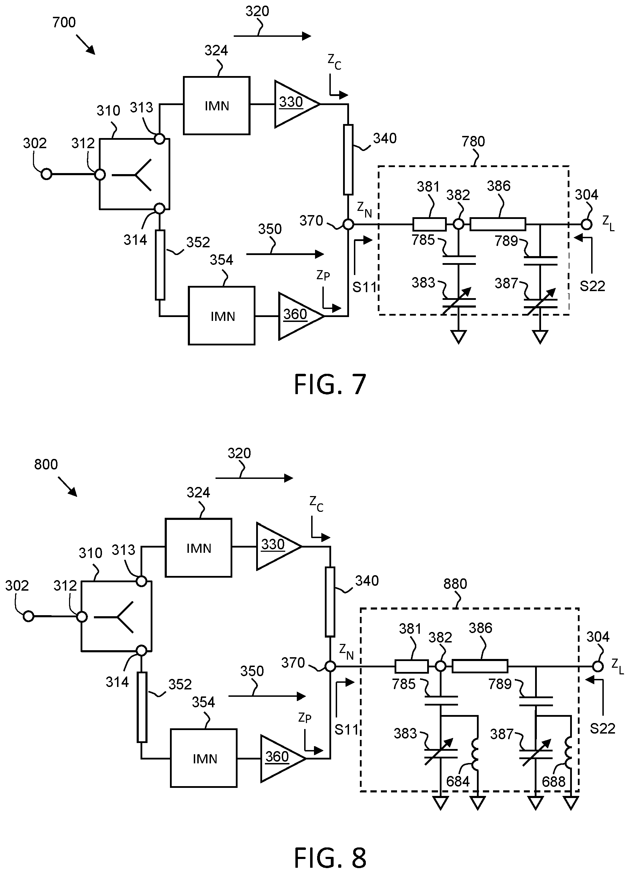

In other cases, when the capacitance tuning range of the two shunt capacitors 383, 387 of FIG. 3 is more than required, it may be desirable to modify the reconfigurable output impedance transformer 380 of FIG. 3 to decrease the insertion loss. For example, FIG. 7 illustrates an embodiment of a Doherty power amplifier 700 with a reconfigurable output impedance transformer 780 that may have a lower insertion loss by including a high quality (Q) fixed capacitor 785, 789 in series with each of the variable capacitors 383, 387.

As with amplifier 300 (FIG. 3), Doherty power amplifier 700 includes an RF input 302, an RF output 304, a signal splitter 310, a carrier amplification path 320, a peaking amplification path 350, and a combining node 370. The carrier amplification path 320 includes a first input IMN 324, a carrier amplifier 330, and a phase shift and impedance inversion element 340. The peaking amplification path 350 includes a phase shift element 352, a second input IMN 354, and a peaking amplifier 360. Each of the above-listed components may be substantially identical to their same-numbered components in FIG. 3, and all details described above for those components are intended to be incorporated into this description of FIG. 7.

The differences between Doherty power amplifier 300 and Doherty power amplifier 700 may be found in the configurations of the reconfigurable output impedance transformers 380, 780. Both reconfigurable transformers 380, 780 include first and second phase shift elements 381, 386 coupled in series between the combining node 370 and the RF output 304, with an intermediate node 382 between the first and second phase shift elements 381, 386. In addition, both of the reconfigurable output impedance transformers 380, 780 include a first variable capacitor 383 (or capacitor network) coupled in a shunt configuration between the intermediate node 382 and a ground reference node, and a second variable capacitor 387 (or capacitor network) coupled in a shunt configuration between the RF output 304 and the ground reference node. Again, each of the above-listed components may be substantially identical to their same-numbered components in FIG. 3, and all details described above for those components are intended to be incorporated into this description of FIG. 7.

As mentioned above, the reconfigurable output impedance transformer 780 differs from the reconfigurable output impedance transformer 380 (FIG. 3) by including a first high-Q fixed capacitor 785 in series with the first variable capacitor 383, and by including a second high-Q fixed capacitor 789 in series with the second variable capacitor 387. The first fixed capacitor 785 has a first terminal coupled to (e.g., indirectly or directly connected to) the intermediate node 382 (i.e., to the output end of element 381 and to the input end of element 386), and a second terminal coupled to (e.g., indirectly or directly connected to) the first terminal of the first variable capacitor 383 (with the second terminal of the first variable capacitor 383 coupled to the ground reference node, as indicated previously). The second fixed capacitor 789 has a first terminal coupled to (e.g., indirectly or directly connected to) the RF output 304 (i.e., to the output end of element 386), and a second terminal coupled to (e.g., indirectly or directly connected to) the first terminal of the second variable capacitor 387 (with the second terminal of the second variable capacitor 387 coupled to the ground reference node, as indicated previously). According to other embodiments, the series order of the fixed capacitors 785, 789 and the variable capacitors 383, 387 may be reversed (i.e., the variable capacitors 383, 387 may be directly connected to node 382 and RF output 304, respectively, and the fixed capacitors 785, 789 may be directly connected to the ground reference node). In various embodiments, the first and second fixed capacitors 785, 789 may be implemented with discrete surface-mount components or other suitable types of capacitors.

In accordance with the above-given example, when the Doherty power amplifier 700 is designed to operate at a fundamental frequency, *f0*, of about 3.6 GHz, when the phase shift element 386 is designed to have a phase shift, *θ*₂, of about 30 degrees, and when the first and second variable capacitors 383, 387 are designed to have a reconfigurable capacitance value in ranges of about 0.47 pF to about 1.77 pF or about 0.30 pF to about 0.95 pF, respectively, the first fixed capacitor 785 may be selected to have a capacitance in a range of about 1.5 pF to about 8.0 pF, and the second fixed capacitor 789 may be selected to have a capacitance in a range of about 1.5 pF to about 8.0 pF. It should be noted here that the capacitance ranges of the first and second fixed capacitors 785, 789 may be different for different fundamental frequencies of operation.

When the reconfigurable output impedance transformers 380, 780 are compared, it may be apparent that the series combination of the first fixed capacitor 785 and the first variable capacitor 383 may have a decreased insertion loss, and the series combination of the second fixed capacitor 789 and the second variable capacitor 387 also may have a decreased insertion loss. The configuration shown in FIG. 7 may be particularly desired when it is desired to decrease the overall insertion loss of the reconfigurable output impedance transformer 780.

In still other embodiments, it may be desirable to achieve the added benefits of both of the alternative reconfigurable output impedance transformers 680, 780 (FIGs 6, 7). For example, FIG. 8 illustrates an embodiment of a Doherty power amplifier 800 with a reconfigurable output impedance transformer 880 that may provide an increased tuning range, and that also may have a lower insertion loss, in comparison with the reconfigurable transformer 380 of FIG. 3. Specifically, like transformer 680 (FIG. 6), the reconfigurable output impedance transformer 880 includes shunt inductors 684, 688 in parallel with each of the variable capacitors 383, 387, and like transformer 780 (FIG. 7), the reconfigurable output impedance transformer 880 includes a high-Q fixed capacitor 785, 789 in series with each of the variable capacitors 383, 387.

As with amplifier 300 (FIG. 3), Doherty power amplifier 800 includes an RF input 302, an RF output 304, a signal splitter 310, a carrier amplification path 320, a peaking amplification path 350, and a combining node 370. The carrier amplification path 320 includes a first input IMN 324, a carrier amplifier 330, and a phase shift and impedance inversion element 340. The peaking amplification path 350 includes a phase shift element 352, a second input IMN 354, and a peaking amplifier 360. Each of the above-listed components may be substantially identical to their same-numbered components in FIG. 3, and all details described above for those components are intended to be incorporated into this description of FIG. 8.

The differences between Doherty power amplifier 300 and Doherty power amplifier 800 may be found in the configurations of the reconfigurable output impedance transformers 380, 880. Both reconfigurable transformers 380, 880 include first and second phase shift elements 381, 386 coupled in series between the combining node 370 and the RF output 304, with an intermediate node 382 between the first and second phase shift elements 381, 386. In addition, both of the reconfigurable output impedance transformers 380, 880 include a first variable capacitor 383 (or capacitor network) coupled in a shunt configuration between the intermediate node 382 and a ground reference node, and a second variable capacitor 387 (or capacitor network) coupled in a shunt configuration between the RF output 304 and the ground reference node. Again, each of the above-listed components may be substantially identical to their same-numbered components in FIG. 3, and all details described above for those components are intended to be incorporated into this description of FIG. 8.

As mentioned above, the reconfigurable output impedance transformer 880 differs from the reconfigurable output impedance transformer 380 (FIG. 3) by including a first shunt inductor 684 in parallel with the first variable capacitor 383, and by including a second shunt inductor 688 in parallel with the second variable capacitor 387. In addition, transformer 880 differs from transformer 380 by including a first high-Q fixed capacitor 785 in series with the first variable capacitor 383, and by including a second high-Q fixed capacitor 789 in series with the second variable capacitor 387. The first and second shunt inductors 684, 688 may be substantially identical to their same-numbered counterparts in FIG. 6, and the details of inductors 684, 688 discussed above in conjunction with FIG. 6 are incorporated into this description of FIG. 8. Additionally, the first and second fixed capacitors 785, 789 may be substantially identical to their same-numbered counterparts in FIG. 7, and the details of capacitors 785, 789 discussed above in conjunction with FIG. 7 are incorporated into this description of FIG. 8.

When the reconfigurable output impedance transformers 380, 880 are compared, it may be apparent that the parallel combination of the first variable capacitor 383 and the first shunt inductor 684 may have an increased tuning range, and the parallel combination of the second variable capacitor 387 and the second shunt inductor 688 may have an increased tuning range. In addition, the series combination of the first fixed capacitor 785 and the first variable capacitor 383 may have a decreased insertion loss, and the series combination of the second fixed capacitor 789 and the second variable capacitor 387 also may have a decreased insertion loss. The configuration shown in FIG. 8 may be particularly desired when the capacitance tuning ranges of the first and second variable capacitors 383, 387 is less than desired or required, and also when it is desired to decrease the overall insertion loss of the reconfigurable output impedance transformer 880.

The Doherty power amplifiers 300, 600, 700, 800 (FIGs 3, 6-8) may be physically implemented using a variety of active and passive electrical devices, which may be housed in one or more device packages and/or on one or more printed circuit boards (PCBs) and/or other substrates. More specifically, various components of the Doherty power amplifiers 300, 600, 700, 800 (FIGs 3, 6-8) may be implemented in self-contained modules or electrical devices, which may be coupled to a substrate that electrically connects the module/devices to other portions of an RF transceiver system (e.g., systems 100, 200, FIGs 1, 2). As used herein, the term "module" means a set of active and/or passive electrical devices (e.g., ICs and components) that are physically contained within a single housing (e.g., the device(s) are coupled to a common "module substrate" or within a single device package). A "module" also includes a plurality of conductive terminals for electrically connecting the set of devices to external circuitry that forms other portions of an electrical system. Essentially, the module substrate configuration, the method of coupling the device(s) to the module's terminals, and the number of devices within the module defines the module type. For example, in various embodiments, a module may be in the form of a PCB-based system, a surface mount device, a chip carrier device, a ball, pin, or land grid array device, a flat package device (e.g., a quad or dual flat no-lead package), a chip scale packaged device, a system-in-package (SiP) device, or in the form of some other type of integrated circuit package. Although a particular type of module/device is described below in conjunction with FIG. 9, it is to be understood that embodiments of the inventive subject matter may be included in other types of modules/devices, as well.

FIG. 9 is a top view of a power amplifier module 900 that embodies a Doherty power amplifier 901 (e.g., amplifier 800, FIG. 8), in accordance with an example embodiment. Various components of power amplifier module 900 correspond with components depicted in FIG. 8, and it should be noted that corresponding components between FIG. 8 and FIG. 9 have the same last two numerical digits (e.g., components 880 and 980 are corresponding circuits).

Power amplifier module 900 includes a module substrate 908 in the form of a multiple-layer printed circuit board (PCB) or other suitable substrate. The module substrate 908 has a top surface 909 (also referred to as a "mounting surface") and a bottom surface (not shown). During fabrication, a plurality of components and terminals are coupled to the mounting surface 909 of the module substrate 908, and non-conductive encapsulant material (e.g., a plastic encapsulant, not shown) may be disposed on the mounting surface 909 and over the components and terminals to define a top surface of the module 900. In addition, a plurality of conductive terminals (e.g., terminals 902, 904) may extend through the module substrate 908 to provide a terminal array at the bottom surface of the module 900. This enables the module 900 to be surface mounted onto a system substrate (not shown).

The module substrate 908 includes a plurality of dielectric layers (e.g., formed from FR-4, ceramic, or other PCB dielectric materials) in an alternating arrangement with a plurality of conductive layers. An uppermost conductive layer may be patterned to include multiple conductive features at the top surface 909 of the module substrate 908. For example, the uppermost conductive layer may include a plurality of conductive pads that serve as attachment points for various discrete components, and additional conductive features (e.g., conductive traces and transmission line segments) that provide electrical connectivity between the various features and components of the module 900. Other underlying patterned conductive layers may function as signal routing layers, ground layers, bias voltage conducting layers, heat sink attachment layers, and so on.

According to an embodiment, the module substrate 908 also includes one or more thermal dissipation structures 916, which extend between the top and bottom surfaces of the module substrate 908. Power amplifier dies 933, 934, 953, 954, which are associated with the carrier and peaking amplifiers 930, 960, are physically and electrically coupled to surfaces of the thermal dissipation structures 916 that are exposed at the top surface 909 of the module substrate 908. The bottom surfaces (not shown) of the thermal dissipation structures 916 may be exposed at the bottom surface of the module substrate 908, or the bottom surfaces of the thermal dissipation structures 916 may be covered with a bottom conductive layer (not shown). Either way, the thermal dissipation structures 916 are configured to provide a thermal pathway between the dies 933, 934, 953, 954 and the bottom surfaces of the thermal dissipation structures 916 (and thus the bottom surface of the module substrate 908). In various embodiments, the thermal dissipation structures 916 may include electrically and thermally conductive metallic coins, thermal vias, or other suitable structures. When incorporated into a larger electrical system, the bottom surfaces of the thermal dissipation structures 916 (or the portion of the conductive layer overlying those surfaces) are physically and thermally coupled to a heat sink (not shown).

The Doherty power amplifier 901 embodied in the power amplifier module 900 includes an RF input terminal 902 (e.g., RF input 302, FIGs 3, 6-8), an RF output terminal 904 (e.g., RF output 304, FIGs 3, 6-8), a signal splitter 910 (e.g., signal splitter 310, FIGs 3, 6-8), a carrier amplification path 920 (e.g., carrier amplifier path 320, FIGs 3, 6-8), a peaking amplification path 950 (e.g., peaking amplification path 350, FIGs 3, 6-8), a combining node 970 (e.g., combining node 370, FIGs 3, 6-8), and a reconfigurable output impedance transformer 980 (e.g., reconfigurable transformer 880, FIG. 8).

Terminal 902 functions as the RF signal input terminal for the Doherty power amplifier 901. The RF signal input terminal 902 is electrically coupled to the signal splitter 910. The signal splitter 910, which is coupled to the mounting surface 909 of the module substrate 908, may include one or more discrete die and/or components, although it is represented in FIG. 9 as a single element. The signal splitter 910 includes an input terminal and two output terminals (not numbered, but corresponding to terminals 312-314, FIGs 3, 6-8). The splitter input terminal is electrically coupled through one or more conductive structures (e.g., traces and/or wirebonds, as shown) to the RF signal input terminal 902, and thus is configured to receive an input RF signal.

The signal splitter 910 is configured to split the power of the input RF signal received through the RF input terminal 902 into first and second RF signals (referred to as carrier and peaking signals, respectively), which are produced at the output terminals of the signal splitter 910. When the Doherty power amplifier 901 is a symmetric amplifier, the carrier and peaking signals produced at the outputs of the signal splitter 910 may have equal power. Conversely, when the Doherty power amplifier 901 is an asymmetric amplifier, the carrier and peaking signals produced at the outputs of the signal splitter 910 may have unequal power.

The first output of the signal splitter is electrically coupled to the carrier amplification path 920 (e.g., path 320, FIGs 3, 6-8), and the second output of the signal splitter is electrically coupled to the peaking amplification path 950 (e.g., path 350, FIGs 3, 6-8). The carrier amplification path 920 includes an input impedance matching network (IMN) 924 (e.g., input IMN 324, FIGs 3, 6-8), a carrier amplifier 930 (e.g., amplifier 330, FIGs 3, 6-8), and a phase shift and impedance inversion element 940 (e.g., element 340, FIGs 3, 6-8). According to some embodiments, the peaking amplification path 950 includes a phase shift element 952 (e.g., element 352, FIGs 3, 6-8), an input impedance matching network (IMN) 954 (e.g., input IMN 354, FIGs 3, 6-8), and a peaking amplifier 960 (e.g., amplifier 360, FIGs 3, 6-8). As discussed previously, the phase shift element 952 is configured to impart about a phase shift (e.g., about 90 degrees) to the peaking signal in order to compensate for a phase shift applied along the carrier amplification path 920 (e.g., by phase shift and impedance inversion element 940). In an alternate embodiment, the phase shift element 952 may be omitted, and the signal splitter 910 may include one or more phase shift elements configured to impart about a 90 degree phase difference between the carrier and peaking signals provided at the splitter output terminals. For example, the peaking signal produced at the second signal splitter output may be delayed by about 90 degrees from the carrier signal produced at the first signal splitter output. In other words, the RF signal provided to the peaking amplifier path may be delayed by about 90 degrees from the RF signal provided to the carrier amplifier path.

In the specific embodiment of FIG. 9, each of the carrier and peaking amplifier paths includes a two-stage power amplifier 930, 960, where a driver amplifier transistor 936, 956 is implemented on a driver amplifier die 933, 953, and a final-stage amplifier transistor 937, 957 is implemented on a separate final-stage amplifier die 934, 954. For example, each of the transistors 936, 937, 956, 957 may be a field effect transistor (FET), such as a laterally-diffused metal oxide semiconductor (LDMOS) FET or a high electron mobility transistor (HEMT). The description may refer to each transistor as including a control terminal and two current-conducting terminals. For example, using terminology associated with FETs, a "control terminal" refers to a gate terminal of a transistor, and first and second current-conducting terminals refer to drain and source terminals (or vice versa) of a transistor. Although the below description may use terminology commonly used in conjunction with FET devices, the various embodiments are not limited to implementations the utilize FET devices, and instead are meant to apply also to implementations that utilize bipolar junction transistors (BJT) devices or other suitable types of transistors.

In some embodiments, the carrier amplifier 930 more specifically includes a silicon driver stage die 933 and a gallium nitride (GaN) final-stage die 934. The peaking amplifier 960 also includes a silicon driver stage die 953 and a GaN final-stage die 954, in accordance with some embodiments. In other embodiments, each of the carrier and peaking amplifiers 930, 960 may include a two-stage power amplifier implemented on a single die, or each of the carrier and peaking amplifiers 930, 960 may include a single-stage power amplifier implemented on a single die. In still other embodiments, each of the carrier and peaking amplifiers may include a two-stage power amplifier implemented on separate driver and final-stage dies, but the driver and final-stage dies may be formed using the same semiconductor technology (e.g., both the driver and final-stage dies are silicon dies or GaN dies), or the driver and/or final-stage dies may be formed using different semiconductor technologies than those described above (e.g., the driver and/or final-stage dies may be formed from silicon germanium (SiGe) and/or gallium arsenide (GaAs)).

The carrier amplifier path 920 includes the above-mentioned driver stage die 933, the final-stage die 934, and a phase shift and impedance inversion element 940 (e.g., element 340, FIGs 3, 6-8). The driver stage die 933 and the final-stage die 934 of the carrier amplifier path 920 are electrically coupled together in a cascade arrangement between an input terminal 935 of the driver stage die 933 (corresponding to a carrier amplifier input) and an output terminal 938 of the final-stage die 934 (corresponding to a carrier amplifier output).

The driver stage die 933 includes a plurality of integrated circuits. In an embodiment, the integrated circuitry of die 933 includes a series-coupled arrangement of the input terminal 935, an input impedance matching circuit (not numbered), a silicon power transistor 936, an integrated portion of an interstage impedance matching circuit (not numbered), and an output terminal not numbered, in an embodiment. More specifically, the gate of the transistor 936 is electrically coupled through the input impedance matching circuit to the input terminal 935, and the drain of the transistor 936 is electrically coupled through the output impedance matching circuit to the output terminal of die 933. The source of transistor 936 is electrically coupled to a conductive layer on a bottom surface of die 933, and the bottom conductive layer is physically, electrically, and thermally coupled to the exposed top surface of one of the thermal dissipation structures 916.

The output terminal of the driver stage die 933 is electrically coupled to the input terminal of the final-stage die 934 through a wirebond array (not numbered) or another type of electrical connection. The final-stage die 934 also includes a plurality of integrated circuits. In an embodiment, the integrated circuitry of die 934 includes a series-coupled arrangement of an input terminal (not numbered), a GaN power transistor 937, and an output terminal 938. More specifically, the gate of the transistor 937 is electrically coupled to the input terminal of die 934, and the drain of the transistor 937 is electrically coupled to the output terminal 938 of die 934. The source of transistor 937 is electrically coupled to a conductive layer on a bottom surface of die 934, and the bottom conductive layer is physically, electrically, and thermally coupled to the exposed top surface of the thermal dissipation structure 316.

The peaking amplifier path includes the above-mentioned driver stage die 953 and the final-stage die 954. The driver stage die 953 and the final-stage die 954 of the peaking amplifier path 950 are electrically coupled together in a cascade arrangement between an input terminal 955 of the driver stage die 953 (corresponding to a peaking amplifier input) and an output terminal 958 of the final-stage die 954 (corresponding to a peaking amplifier output).

The driver stage die 953 includes a plurality of integrated circuits. In an embodiment, the integrated circuitry of die 953 includes a series-coupled arrangement of the input terminal 955, an input impedance matching circuit (not numbered), a silicon power transistor 956, an integrated portion of an interstage impedance matching circuit (not numbered), and an output terminal (not numbered), in an embodiment. More specifically, the gate of the transistor 956 is electrically coupled through the input impedance matching circuit to the input terminal 955, and the drain of the transistor 956 is electrically coupled through the output impedance matching circuit to the output terminal of die 953. The source of transistor 956 is electrically coupled to a conductive layer on a bottom surface of die 953, and the bottom conductive layer is physically, electrically, and thermally coupled to the exposed top surface of one of the thermal dissipation structures 916.

The output terminal of the driver stage die 953 is electrically coupled to the input terminal of the final-stage die 954 through a wirebond array (not numbered) or another type of electrical connection. The final-stage die 954 also includes a plurality of integrated circuits. In an embodiment, the integrated circuitry of die 954 includes a series-coupled arrangement of an input terminal (not numbered), a GaN power transistor 957, and an output terminal 958. More specifically, the gate of the transistor 957 is electrically coupled to the input terminal of die 954, and the drain of the transistor 957 is electrically coupled to the output terminal 958 of die 954. The source of transistor 957 is electrically coupled to a conductive layer on a bottom surface of die 954, and the bottom conductive layer is physically, electrically, and thermally coupled to the exposed top surface of the thermal dissipation structure 916.

An amplified carrier signal is produced at the output terminal 938 of the final-stage die 934, and an amplified peaking signal is produced at the output terminal 958 of the final-stage die 954. In the illustrated embodiment, the output terminal 958 of the final-stage die 954 also functions as the combining node 970 (e.g., node 370, FIGs 3, 6-8) for the amplifier 901. According to an embodiment, the output terminal 938 of the carrier final-stage die 934 is electrically coupled (e.g., through wirebonds (not numbered) or another type of electrical connection) to a first end of the phase shift and impedance inversion element 940, and a second end of the phase shift and impedance inversion element 940 is electrically coupled (e.g., through wirebonds (not numbered) or another type of electrical connection) to the output terminal 958 of the peaking final-stage die 954, and thus to the combining node 970.

According to an embodiment, the phase shift and impedance inversion element 940 may be implemented with a quarter-wavelength or lambda/4 (λ/4) or shorter transmission line (e.g., a microstrip transmission line with an electrical length up to about 90 degrees). As used herein, lambda is the wavelength of an RF signal at the fundamental frequency of operation of the amplifier (e.g., a frequency in a range of about 600 megahertz (MHz) to about 10 gigahertz (GHz) or higher). The combination of the phase shift and impedance inversion element 940 and the wirebond (or other) connections to the output terminals 938, 958 of dies 934, 954 may impart about a 90 degree relative phase shift to the amplified carrier signal as the signal travels from output terminal 938 to output terminal 958/combining node 970. When the various phase shifts imparted separately on the carrier and peaking RF signals through the carrier and peaking paths, respectively, are substantially equal, the amplified carrier and peaking RF signals combine substantially in phase at output terminal 958/combining node 970.

The output terminal 958/combining node 970 is electrically coupled (e.g., through wirebonds or another type of electrical connection) to a reconfigurable output impedance transformer 980 (e.g., reconfigurable transformer 880, FIG. 8). In the embodiment illustrated in FIG. 9, the components of the reconfigurable output impedance transformer 980 correspond to the components of the reconfigurable output impedance transformer 880 (FIG. 8). Those of skill in the art would understand, based on the description herein, that alternate embodiments of module 900 may, instead, have a reconfigurable output impedance transformer that has components that correspond to any of reconfigurable output impedance transformers 380, 680, or 780 (FIGs 3, 6, and 7). Either way, the reconfigurable output impedance transformer 980 is coupled to RF output terminal 904 (e.g., RF output 304, FIGs 3, 6-8). As discussed in detail previously, the reconfigurable output impedance matching transformer 980 functions to present the proper load impedances to the combining node 970 (and thus, to each of carrier and peaking final-stage dies 934, 954).

According to one or more embodiments, the reconfigurable output impedance transformer 980 may include first and second phase shift elements 981, 986 (e.g., elements 381, 386, FIGs 3, 6-8) coupled in series between the combining node 970 and the RF output 904, with an intermediate node 982 (e.g., node 382, FIGs 3, 6-8) between the first and second phase shift elements 981, 986. For example, the first phase shift element 981 may be implemented as a first conductive trace or first transmission line, which has a first end coupled (e.g., through wirebonds, not numbered) to the combining node 970, and a second end that corresponds to the intermediate node 982. The second phase shift element 986 may be implemented as a second conductive trace or second transmission line, which may be an extension of the first conductive trace or the first transmission line. Either way, the second phase shift element 986 has a first end corresponding to the intermediate node 982, and a second end coupled to the RF output terminal 904. In some embodiments, a decoupling capacitor 992 may be coupled between the second end of the second phase shift element 986 and the RF output terminal 904.

In addition, according to one or more embodiments, the reconfigurable output impedance transformer 980 includes a first variable capacitor 983 (e.g., capacitor 383, FIGs 3, 6-8) (or capacitor network) coupled in a shunt configuration between the intermediate node 982 and a ground reference node 990, and a second variable capacitor 987 (e.g., capacitor 387, FIGs 3, 6-8) (or capacitor network) coupled in a shunt configuration between the RF output 904 and the ground reference node 990. For example, the ground reference node 990 may be implemented as one or more conductive traces at the top surface 909 of the module substrate 908, which are electrically connected to one or more ground terminals (not illustrated) on the bottom surface of the module substrate 908 (e.g., terminal(s) that are configured to be coupled to system ground).

In addition, according to one or more embodiments, the reconfigurable output impedance transformer 980 includes a first shunt inductor 984 (e.g., inductor 684, FIGs 6, 8) coupled in parallel with the first variable capacitor 983, and a second shunt inductor 988 (e.g., inductor 688, FIGs 6, 8) coupled in parallel with the second variable capacitor 987. The first and second shunt inductors 984, 988 may be substantially identical to inductors 684, 688 discussed in conjunction with FIG. 6, and the details of inductors 684, 688 discussed above in conjunction with FIG. 6 are incorporated into this description of FIG. 9. In other embodiments, inductors 984, 988 may be excluded from module 900.

Further still, according to one or more embodiments, the reconfigurable output impedance transformer 980 includes a first high-Q fixed capacitor 985 (e.g., capacitor 785, FIGs 7, 8) coupled in series with the first variable capacitor 983, and a second high-Q fixed capacitor 989 (e.g., capacitor 789, FIGs 7, 8) coupled in series with the second variable capacitor 987. The first and second fixed capacitors 985, 989 may be substantially identical to capacitors 785, 789 discussed in conjunction with FIG. 7, and the details of capacitors 785, 789 discussed above in conjunction with FIG. 7 are incorporated into this description of FIG. 9. In other embodiments, capacitors 785, 789 may be excluded from module 900, in which case the variable capacitors 983, 987 would be directly coupled between the intermediate node 982 or the RF output terminal 904, respectively, and the ground reference node 990.

As discussed previously, by including a reconfigurable output impedance transformer (e.g., any of transformers 380, 680, 780, 880, 980, FIGs 3, 6-9), the transformer 980 is adapted to transform a range of load impedances to the impedance at the combining node 970 while maintaining excellent RF performance, and without significant insertion losses. Further, when the reconfigurable output impedance transformer incudes shunt inductors 984, 988 (e.g., inductors 684, 688, FIGs 6, 8) in parallel with the variable shunt capacitors 983, 987 (e.g., capacitors 383, 387, FIGs 3, 6, 8), the tuning ranges of the reconfigurable output impedance transformer may be increased. Further still, when the reconfigurable output impedance transformer includes high-Q capacitors 985, 989 (e.g., capacitors 785, 789, FIGs 3, 7, 8) in series with the variable shunt capacitors 983, 987, the reconfigurable output impedance transformer may have a further decreased insertion loss.

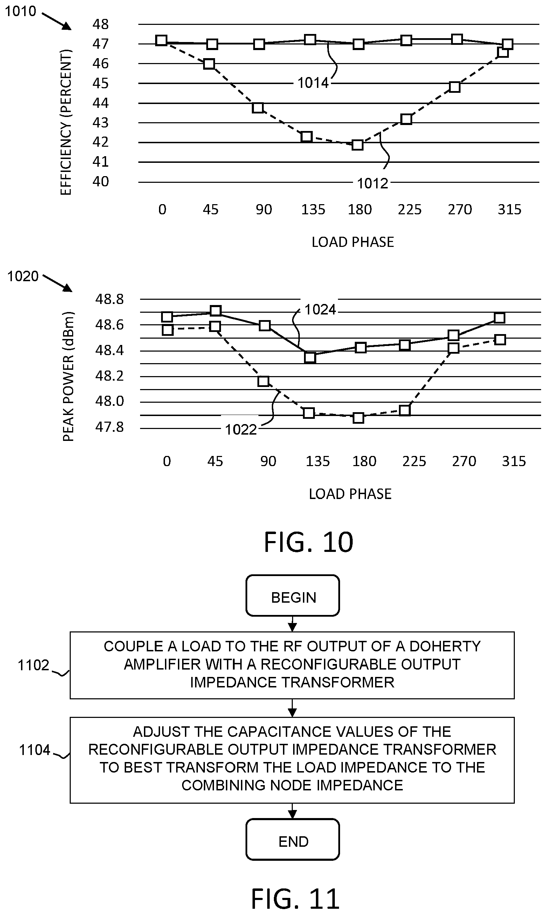

FIG. 10 includes two graphs 1010, 1020 that compare loadpull results for various RF performance characteristics of a conventional Doherty amplifier with a fixed output impedance transformer with an embodiment of a Doherty power amplifier with a reconfigurable output impedance transformer (e.g., transformer 380, FIG. 3). More specifically, graph 1010 includes a first trace 1012 that tracks the efficiency (vertical axis) of a conventional Doherty amplifier with a fixed output impedance transformer as a function of load phase (horizontal axis), and a second trace 1014 that tracks the efficiency of an embodiment of a Doherty power amplifier with a reconfigurable output impedance transformer (e.g., transformer 380, FIG. 3) as a function of load phase. Trace 1012 corresponding to a Doherty power amplifier with a fixed output impedance transformer shows that the amplifier efficiency is significantly lower than the maximum efficiency (e.g., about 47 percent) for some load phases (i.e., for different load impedances). However, trace 1014 corresponding to an embodiment of a Doherty amplifier with a reconfigurable output impedance transformer shows that the amplifier efficiency may be maintained near the maximum efficiency over all load phases through appropriate adjustment of the variable capacitors (e.g., capacitors 383, 387, 983, 987, FIGs 3, 6-9) of the reconfigurable output impedance transformer.

Graph 1020 includes a first trace 1022 that tracks the peak power (vertical axis) of a conventional Doherty amplifier with a fixed output impedance transformer as a function of load phase (horizontal axis), and a second trace 1024 that tracks the peak power of an embodiment of a Doherty power amplifier with a reconfigurable output impedance transformer (e.g., transformer 380, FIG. 3) as a function of load phase. Trace 1022 corresponding to a Doherty power amplifier with a fixed output impedance transformer shows that the peak power is significantly lower than the maximum peak power (e.g., about 48.55 dBm) for some load phases (i.e., for different load impedances). However, trace 1024 corresponding to an embodiment of a Doherty amplifier with a reconfigurable output impedance transformer shows that the peak power may be maintained near the maximum peak power over all load phases through appropriate adjustment of the variable capacitors (e.g., capacitors 383, 387, 983, 987, FIGs 3, 6-9) of the reconfigurable output impedance transformer.

FIG. 11 is a flowchart of a method for configuring an embodiment of a reconfigurable output impedance transformer (e.g., any of reconfigurable transformers 380, 680, 780, 880, 980, FIGs 3, 6-9) of a Doherty power amplifier (e.g., amplifier 300, 600, 700, 800, 900, FIGs 3, 6-9). The method begins, in block 1102, by coupling a load to an RF output (e.g., RF output 304, 904, FIGs 3, 6-9) of a Doherty amplifier (e.g., amplifiers 300, 600, 700, 800, 901, FIGs 3, 6-9). As discussed previously, the load is characterized by a load impedance, *Z_{L},* and the load may include an RF switch (e.g., switch 110, 210,FIGs 1, 2), an antenna (e.g., antenna 140, 240, FIGs 1, 2), a circulator (e.g., circulator 216, FIGs 1, 2) or another load.

In block 1104, the capacitance values of one or more shunt capacitors (e.g., capacitors 383, 387, 983, 987, FIGs 3, 6-9) then may be controlled and/or adjusted to achieve capacitance values that best transform the load impedance, *Z_{L},* at the RF output (e.g., at RF output 304, 904, FIGs 3, 6-9) to the impedance, *Z_{N}*, at combining node (e.g., at combining node 370, 970, FIGs 3, 6-9). As mentioned previously, each of the variable capacitors (e.g., capacitors 383, 387, 983, 987, FIGs 3, 6-9) may be implemented with a tunable capacitor, such as but not by way of limitation, a VVAC, a DVC, a fuse-programmable capacitor bank, or another suitable tunable/variable capacitor. The capacitance values of the first and second variable capacitors may be adjusted by performing an appropriate tuning process. For example, when the first and second variable capacitors are VVACs, adjusting the capacitance values includes changing first and second control voltages that are applied to tuning inputs of the VVACs. Conversely, when the first and second variable capacitors are DVCs, adjusting the capacitance values includes clocking digital codes into the capacitors through their digital interfaces, which results in the capacitors having desired capacitance values. Finally, when the first and second variable capacitors are fuse-programmable capacitor banks, adjusting the capacitance values includes blowing certain ones of the fuses to set desired capacitance values.

In some embodiments, the reconfigurable output impedance transformer may be controlled in an open loop manner. This may be appropriate, for example, when the load impedance, *Z_{L},* is not likely to vary significantly over time. In such a case, the above-described method may be used to "set-and-forget" the variable capacitors to capacitance values that achieve an impedance transformation that results in a lowest forward-to-reflected power ratio and a best RF performance. In other embodiments, the reconfigurable output impedance transformer may be dynamically controlled in a closed loop manner during operation of the amplifier. In such embodiments, the reflected power of the amplifier may be continuously or periodically measured, and the above-described method may be used to change the capacitance values of the variable capacitors to best transform the load impedance, *Z_{L},* to the combining node impedance, *Z_{N}* (e.g., to keep the forward-to-reflected power ratio at or below a threshold).

An embodiment of a Doherty power amplifier includes a carrier amplifier, a peaking amplifier, a combining node, an RF output, and a reconfigurable output impedance transformer. The carrier amplifier has a carrier amplifier input and a carrier amplifier output, and the carrier amplifier is configured to amplify a carrier signal received at the carrier amplifier input, and to produce an amplified carrier signal at the carrier amplifier output. The peaking amplifier has a peaking amplifier input and a peaking amplifier output, and the peaking amplifier is configured to amplify a peaking signal received at the peaking amplifier input, and to produce an amplified peaking signal at the peaking amplifier output. The combining node is coupled to the carrier amplifier output and to the peaking amplifier output, and the combining node is configured to combine the amplified carrier signal and the amplified peaking signal to produce a combined amplified signal. The reconfigurable output impedance transformer is coupled between the combining node and the RF output. The reconfigurable output impedance transformer includes a first phase shift element, a first variable capacitor, and a second variable capacitor. The first phase shift element has an input end coupled to the combining node and an output end coupled to the RF output, and the first phase shift element is configured to apply a first phase shift to the combined amplified signal. The first variable capacitor is coupled to the input end of the first phase shift element. The second variable capacitor coupled to the output end of the first phase shift element.

Another embodiment of a Doherty power amplifier includes a carrier amplifier, a peaking amplifier, a combining node, an RF output, and a reconfigurable output impedance transformer. The carrier amplifier has a carrier amplifier input and a carrier amplifier output, and the carrier amplifier is configured to amplify a carrier signal received at the carrier amplifier input, and to produce an amplified carrier signal at the carrier amplifier output. The peaking amplifier has a peaking amplifier input and a peaking amplifier output, and the peaking amplifier is configured to amplify a peaking signal received at the peaking amplifier input, and to produce an amplified peaking signal at the peaking amplifier output. The combining node is coupled to the carrier amplifier output and to the peaking amplifier output, and the combining node is configured to combine the amplified carrier signal and the amplified peaking signal to produce a combined amplified signal. The reconfigurable output impedance transformer is coupled between the combining node and the RF output. The reconfigurable output impedance transformer includes an intermediate node, first and second phase shift elements, and first and second variable capacitors. The first phase shift element has an input end coupled to the combining node and an output end coupled to the intermediate node, and the first phase shift element is configured to apply a first phase shift to the combined amplified signal. The second phase shift element has an input end coupled to the intermediate node and an output end coupled to the RF output, and the second phase shift element is configured to apply a second phase shift to the combined amplified signal. The first variable capacitor is coupled between the input end of the second phase shift element and a ground reference node, and the second variable capacitor is coupled between the output end of the second phase shift element and the ground reference node.

In one or more embodiments, the first phase shift is in a range of 0 degrees to 15 degrees; and the second phase shift is in a range of 15 degrees to 45 degrees.

In one or more embodiments, the reconfigurable output impedance transformer further comprises: a first inductor coupled between the first terminal of the first variable capacitor and the ground reference node; and a second inductor coupled between the first terminal of the second variable capacitor and the ground reference node.

In one or more embodiments, the reconfigurable output impedance transformer further comprises: a first fixed capacitor coupled in series with the first variable capacitor between the input end of the first phase shift element and the ground reference node; and a second fixed capacitor coupled in series with the second variable capacitor between the output end of the first phase shift element and the ground reference node.

An embodiment of a method of reconfiguring a Doherty power amplifier includes coupling a load to an RF of a Doherty power amplifier, where the load is characterized by a load impedance. The Doherty power amplifier includes a carrier amplifier, a peaking amplifier, a combining node, an RF output, and a reconfigurable output impedance transformer. The carrier amplifier has a carrier amplifier input and a carrier amplifier output, and the carrier amplifier is configured to amplify a carrier signal received at the carrier amplifier input, and to produce an amplified carrier signal at the carrier amplifier output. The peaking amplifier has a peaking amplifier input and a peaking amplifier output, and the peaking amplifier is configured to amplify a peaking signal received at the peaking amplifier input, and to produce an amplified peaking signal at the peaking amplifier output. The combining node is coupled to the carrier amplifier output and to the peaking amplifier output, and the combining node is configured to combine the amplified carrier signal and the amplified peaking signal to produce a combined amplified signal. The reconfigurable output impedance transformer is coupled between the combining node and the RF output. The reconfigurable output impedance transformer includes a first phase shift element, a first variable capacitor, and a second variable capacitor. The first phase shift element has an input end coupled to the combining node and an output end coupled to the RF output, and the first phase shift element is configured to apply a first phase shift to the combined amplified signal. The first variable capacitor is coupled to the input end of the first phase shift element. The second variable capacitor coupled to the output end of the first phase shift element. The method also includes adjusting a first capacitance value of the first variable capacitor and a second capacitance value of the second variable capacitor to transform the load impedance to the combining node impedance.

In one or more embodiments: the load impedance is in a range of 40 ohms to 60 ohms; and the combining node impedance is in a range of 10 ohms to 30 ohms.

In one or more embodiments, each of the first and second variable capacitors is a capacitor selected from a voltage-controlled variable capacitor, a digitally-controlled variable capacitor, and a fuse-programmable capacitor bank; and adjusting the first capacitance value of the first variable capacitor and the second capacitance value of the second variable capacitor includes performing a tuning process selected from changing first and second control voltages applied to the first and second variable capacitors, clocking digital codes into the first and second variable capacitors, and blowing fuses to set the first and second capacitance values.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

As used herein, the words "exemplary" and "example" mean "serving as an example, instance, or illustration." Any implementation described herein as exemplary or an example is not necessarily to be construed as preferred or advantageous over other implementations. Furthermore, there is no intention to be bound by any expressed or implied theory presented in the preceding technical field, background, or detailed description.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A Doherty power amplifier comprising:
a carrier amplifier with a carrier amplifier input and a carrier amplifier output, wherein the carrier amplifier is configured to amplify a carrier signal received at the carrier amplifier input, and to produce an amplified carrier signal at the carrier amplifier output;
a peaking amplifier with a peaking amplifier input and a peaking amplifier output, wherein the peaking amplifier is configured to amplify a peaking signal received at the peaking amplifier input, and to produce an amplified peaking signal at the peaking amplifier output;
a combining node coupled to the carrier amplifier output and to the peaking amplifier output, wherein the combining node is configured to combine the amplified carrier signal and the amplified peaking signal to produce a combined amplified signal;
a radio frequency (RF) output; and
a reconfigurable output impedance transformer coupled between the combining node and the RF output, wherein the reconfigurable output impedance transformer includes
a first phase shift element with an input end coupled to the combining node and an output end coupled to the RF output, wherein the first phase shift element is configured to apply a first phase shift to the combined amplified signal,
a first variable capacitor coupled to the input end of the first phase shift element, and
a second variable capacitor coupled to the output end of the first phase shift element.

2. The Doherty power amplifier of claim 1, wherein the first phase shift is in a range of 15 degrees to 45 degrees.

3. The Doherty power amplifier of claim 1 or 2, wherein the reconfigurable output impedance transformer further comprises:
an intermediate node connected to the input end of the first phase shift element; and
a second phase shift element with an input end coupled to the combining node, and an output end coupled to the intermediate node and to the input end of the first phase shift element, wherein the second phase shift element is configured to apply a second phase shift to the combined amplified signal.

4. The Doherty power amplifier of claim 3, wherein the second phase shift is in a range of 0 degrees to 15 degrees.

5. The Doherty power amplifier of any preceding claim, wherein:
the first variable capacitor has a first terminal that is coupled to the input end of the first phase shift element, and a second terminal that is coupled to a ground reference node; and
the second variable capacitor has a first terminal that is coupled to the output end of the first phase shift element, and a second terminal that is coupled to the ground reference node.

6. The Doherty power amplifier of claim 5, wherein the reconfigurable output impedance transformer further comprises:
a first inductor coupled between the first terminal of the first variable capacitor and the ground reference node; and
a second inductor coupled between the first terminal of the second variable capacitor and the ground reference node.

7. The Doherty power amplifier of claim 5 or 6, wherein the reconfigurable output impedance transformer further comprises:
a first fixed capacitor coupled in series with the first variable capacitor between the input end of the first phase shift element and the ground reference node; and
a second fixed capacitor coupled in series with the second variable capacitor between the output end of the first phase shift element and the ground reference node.

8. The Doherty power amplifier of claim 7, wherein the reconfigurable output impedance transformer further comprises:
a first inductor coupled between the first terminal of the first variable capacitor and the ground reference node; and
a second inductor coupled between the first terminal of the second variable capacitor and the ground reference node.

9. The Doherty power amplifier of any preceding claim, wherein each of the first and second variable capacitors is a capacitor selected from a voltage-controlled variable capacitor, a digitally-controlled variable capacitor, and a fuse-programmable capacitor bank.

10. The Doherty power amplifier of any preceding claim, wherein each of the first and second variable capacitors is **characterized by** a tuning ratio of 5.0 or less.

11. The Doherty power amplifier of any preceding claim, wherein:
the RF output is configured to be coupled to a load that is **characterized by** a load impedance; and
the combining node is **characterized by** a combining node impedance that is half or less of the load impedance.

12. The Doherty power amplifier of any preceding claim, wherein:
the RF output is configured to be coupled to a load that is **characterized by** a load impedance in a range of 40 ohms to 60 ohms; and
the combining node is **characterized by** a combining node impedance that is in a range of 10 ohms to 30 ohms.

13. The Doherty power amplifier of any preceding claim, further comprising:
a signal splitter with a splitter input, a first splitter output coupled to the carrier amplifier input, and a second splitter output coupled to the peaking amplifier input, wherein the signal splitter is configured to receive an input RF signal and to divide the input RF signal into a carrier RF signal and a peaking RF signal, wherein the carrier RF signal is provided to the carrier amplifier input, and the peaking RF signal is provided to the peaking amplifier input; and
a phase shift and impedance inversion element coupled between the carrier amplifier output and the combining node.
